# EUROPEAN PATENT APPLICATION

(11) **EP 2 397 232 A1**
(43) Date of publication of application: **21.12.2011**
(21) Application number: 11170339.3
(22) Date of filing: 17.06.2011
(51) Int. Cl.: B05D 1/00, G03F 7/16, B05D 3/10

(54) **Coating method and coating apparatus**

(30) Priority: 18.06.2010 JP 2010139410
(71) Applicant: TOKYO ELECTRON LIMITED, Minato-ku Tokyo 107-6325 (JP)
(72) Inventor: Ichino, Katsunori, Kumamoto-ken (JP); Yoshihara, Kentaro, Kumamoto-ken (JP); Yoshihara, Kousuke, Kumamoto-ken (JP)
(74) Representative: HOFFMANN EITLE

(57) **Abstract**

A coating method based on such a technique includes a prewetting step of supplying a prewetting liquid to the center of a substrate (W) and rotating the substrate thereby spreading the prewetting liquid over the whole surface of a first substrate, and a coating film forming step of supplying a coating solution (e.g., a resist solution) to the substrate supplied with the prewetting liquid and drying the coating solution thereby forming a coating film on the surface of the first substrate. The prewetting liquid used is a mixed liquid obtained by mixing a solvent capable of dissolving components of the coating film (e.g., components of resist) and a high surface tension liquid having a surface tension higher than that of the solvent, the mixed liquid having a surface tension higher than that of the coating solution.

## Description

### TECHNICAL FIELD

The present invention generally relates to a technique for applying a coating solution such as a resist. The invention particularly relates to a technique for controlling the surface tension of a prewetting liquid supplied to a substrate prior to the application of a coating solution thereby improving the coatability of the coating solution.

### BACKGROUND ART

A photolithography process in manufacture for semiconductor devices involves a step of coating a resist solution on a semiconductor wafer (hereinafter referred to as "wafer") to form a resist film, a step of exposing the resist film to a predetermined pattern, a step of developing the exposed resist film, and so on, which are performed successively. Through these steps a predetermined resist pattern is formed on a wafer.

A so-called spin-coating method is adopted for the resist coating step in many cases. The spin-coating method is a process in which a resist solution is supplied from a nozzle to the central portion at the surface of a rotating wafer and the resist solution is radially outwardly diffused under a centrifugal force such that the whole surface of the wafer is coated with the resist solution.

With the progress of microfabrication of semiconductor device circuits in recent years, reduction in thickness of the resist film in the resist coating process has proceeded. Since the resist solution is expensive, it is also necessary to decrease the amount of its use as much as possible. In order to coat the whole surface of the wafer with a small amount of resist solution, it becomes more important to improve in-plane uniformity in film thickness of the resist solution.

A prewetting technique is known in the art as means for attaining uniform resist coating with a small discharge amount of resist solution. Prewetting is an operation in which, in order to facilitate uniform coating over the whole surface of the wafer with a small amount of resist solution, a solvent capable of dissolving a resist and referred to as "prewetting thinner" is supplied onto the water before the resist solution is supplied to the wafer. By prewetting, the resist solution tends to uniformly diffuse on the wafer even when a small amount of resist solution is used.

Even if the prewetting is performed, however, the resist solution sometimes cannot uniformly be coated over the whole surface of the wafer. For example, the resist solution diffuses in the radial direction of the wafer and then branches at the peripheral portion of the wafer, as a result of which a number of elongate streaks radially extending occur and thereby the resist is not coated between the adjacent streaks. This phenomenon is referred to as "fingering".

A wafer rotation control technique is another means for attaining uniform resist coating with a small discharge amount of resist solution. According to such a technique, the rotation speed and the rotation acceleration of the wafer are properly controlled on a time basis during supply and diffusion of the resist solution, thereby preventing the resist solution from unnecessarily scattering to the outside of the substrate, and moderating a tendency that the film thickness of the resist decreases at the wafer outer peripheral portion on which a strong centrifugal force acts. However, it is difficult to achieve significant resist saving only by the rotation controlling technique.

Relevant art can be found in JP2009-279476A, JP2009-078250A, JP2003-086489A and JP2003-059825A, for example.

### SUMMARY OF THE INVENTION

The present invention provides a technique allowing the surface of a substrate to be reliably coated with a coating solution such as a resist solution to uniformly form a coating film on the surface of the substrate even if a less amount of coating solution is supplied.

The present invention provides a coating method including: a prewetting step of supplying a prewetting liquid to the center of a first substrate and rotating the first substrate thereby spreading the prewetting liquid over the whole surface of the substrate; and a coating film forming step of supplying a coating solution to the first substrate supplied with the prewetting liquid and drying the coating solution thereby forming a coating film on the surface of the first substrate; the coating film forming step including: a first stage in which the coating solution is supplied to a central portion of the first substrate while the first substrate is rotated; a second stage in which rotation speed of the first substrate is then decreased and then the first substrate is continuously rotated; and a third stage in which the rotation speed of the first substrate is then increased to dry the coating solution on the first substrate, wherein, in the first stage, the first substrate is rotated at a first constant rotation speed immediately before the coating solution is supplied to the first substrate, then the rotation speed of the substrate is gradually increased continuously after starting of supply of the coating solution, and acceleration of the rotation of the first substrate is gradually decreased before completion of discharging of the coating solution, thereby converging the rotation speed of the substrate to a second rotation speed higher than the first rotation speed, and wherein the prewetting liquid used in the prewetting step is a mixed liquid obtained by mixing a solvent capable of dissolving components of the coating film and a high surface tension liquid having a surface tension higher than that of the solvent, the mixed liquid having a surface tension higher than that of the coating solution.

Further, the present invention also provides a coating method comprising: a prewetting step of supplying a prewetting liquid to the center of a first substrate and rotating the first substrate thereby spreading the prewetting liquid over the whole surface of the first substrate; and a coating film forming step of supplying a coating solution to the first substrate supplied with the prewetting liquid and drying the coating solution, thereby forming a coating film on the surface of the first substrate, wherein the prewetting liquid is a mixed liquid, which is obtained by mixing a solvent capable of dissolving components of the coating film and a high surface tension liquid, and which has a surface tension higher than that of the solvent, wherein the solvent and the high surface tension liquid are separately prepared, and wherein the solvent and the high surface tension liquid are mixed when the prewetting liquid is supplied.

Further, the present invention provides a coating apparatus including: a spin chuck for holding and rotating a substrate; at least one coating solution nozzle for supplying a coating solution to the surface of the substrate held by the spin chuck; at least one prewetting nozzle for supplying a prewetting liquid to the surface of the substrate held by the spin chuck; a coating solution supply mechanism for supplying the coating solution to the coating solution nozzle; and a prewetting liquid supply mechanism for supplying the prewetting liquid to the prewetting nozzle, wherein the prewetting liquid supply mechanism includes a prewetting liquid supply control section connected to a supply source for a solvent capable of dissolving components of a coating film and a supply source for a high surface tension liquid having a surface tension higher than that of the solvent, the prewetting liquid supply control section being configured to mix the solvent and the high surface tension liquid and supply the mixture to the prewetting nozzle, and wherein the prewetting liquid supply control section is configured to variably control the mixing ratio of the solvent and the high surface tension liquid.

According to the invention, the surface of the substrate can be uniformly coated with a coating solution by adding the high surface tension liquid to the solvent capable of dissolving the components of the coating film, thereby controlling the surface tension of the prewetting liquid.

### BRIEF DESCRIPTION OF THE DRAWINGS

Fig. 1 is a plan view showing the schematic configuration of a coating and developing system;
Fig. 2 is a front elevational view of the coating and developing system;
Fig. 3 is a rear elevational view of the coating and developing system;
Fig. 4 is a schematic vertical cross sectional view showing a configuration of a resist coating apparatus;
Fig. 5 is a schematic transverse sectional view showing the configuration of the resist coating apparatus;
Fig. 6 is a flow chart showing main steps of resist coating process;
Fig. 7 is a graph showing the rotation speed of a wafer together with supply timing of a prewetting liquid and a resist solution in each of the steps of the resist coating process;
Fig. 8A and 8B are schematic views for explaining the principle of the effect of the surface tension control for the prewetting liquid;
Fig. 9 is a graph showing the result of Experiment 1;
Fig. 10 shows a copy of photographs showing the result of Experiment 1;
Fig. 11 is a table showing the result of Experiment 2;
Fig. 12 is a graph showing the result of Experiment 3; and
Fig. 13 is a schematic view showing a modified example of a prewetting liquid supply mechanism.

### DESCRIPTION OF PREFERRED EMBODIMENTS

Preferred embodiments of the present invention will be described with reference to the accompanying drawings.

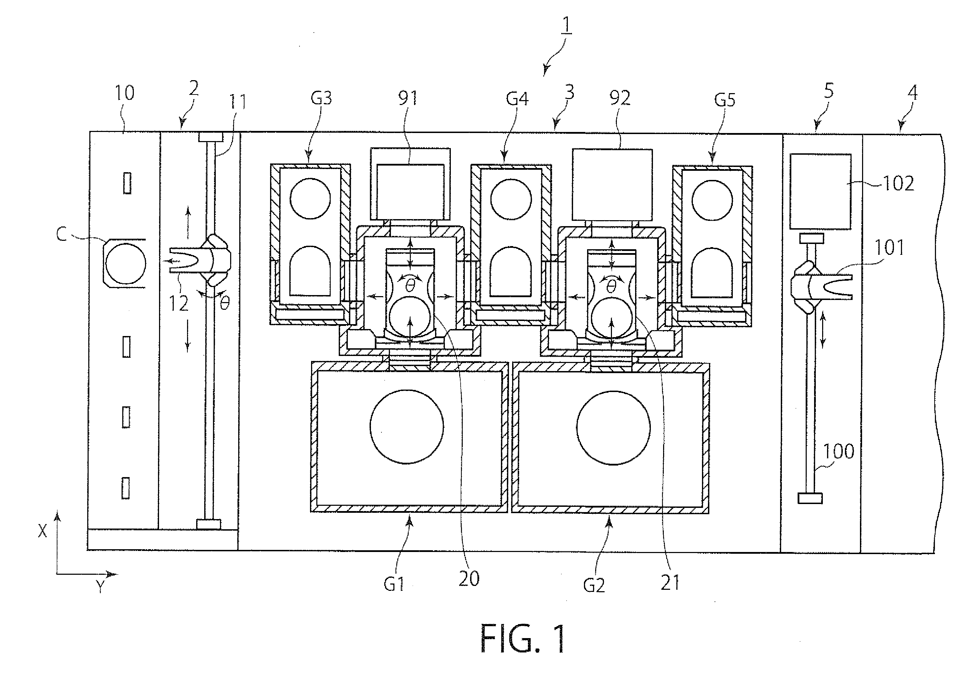

First, the entire configuration of a coating and developing system, into which a coating apparatus for coating a substrate with a resist is incorporated, will be described with reference to Figs. 1 to 3.

As shown in Fig. 1, a coating and developing system 1 includes a cassette station 2 for loading/unloading a cassette containing a plurality of wafers W into/from the outside to the coating and developing system 1; a processing station 3 having a plurality of various processing units (apparatus) each for performing a predetermined single-wafer processing, constituting a photolithography process, to a wafer; and an interface station 5 for transferring wafers W between the processing station 3 and an exposure apparatus 4 adjacent thereto. Those stations are integrally connected.

The cassette station 2 has a cassette loading stage 10 disposed therein. A plurality of cassettes C can be disposed in a row in X direction (in the vertical direction in Fig. 1) in the cassette mounting stand 10. A wafer conveyer 12 capable of moving on a conveying path 11 in X direction is provided in the cassette station 2. The wafer conveyer 12 is movable also in the direction of arranging the wafers W contained in the cassette C (in Z direction; vertical direction), and can selectively access a plurality of wafers W in the cassette C. The wafer conveyer 12 is rotatable about the axis extending vertically (in the direction θ), and can convey the wafers W while accessing each of the processing units in a third processing unit group G3 of the processing station 3, described later.

The processing station 3 has five processing unit groups G1 to G5, for example, in which a plurality of processing units are disposed in a multistage. On the negative X direction side of the processing station 3 (in the downward direction in Fig. 1), a first processing unit group G1 and a second processing unit group G2 are arranged successively from the side of the cassette station 2 to the side of the interface station 5. On the positive X direction side of the processing station 3 (in the upward direction in Fig. 1), a third processing unit group G3, a fourth processing unit group G4, and a fifth processing unit group G5 are arranged successively from the side of the cassette station 2 to the side of the interface station 5. A first transfer device 20 is disposed between the third processing unit group G3 and the fourth processing unit group G4. The first transfer device 20 can transfer the wafer W while selectively accessing each of the units in the first processing unit group G1, the third processing unit group G3, and the fourth processing unit group G4. A second transfer device 21 is disposed between the fourth processing unit group G4 and the fifth processing unit group G5. The second transfer device 21 can transfer the wafers W while selectively accessing each of the units in the second processing unit group G2, the fourth processing unit group G4, and the fifth processing unit group G5.

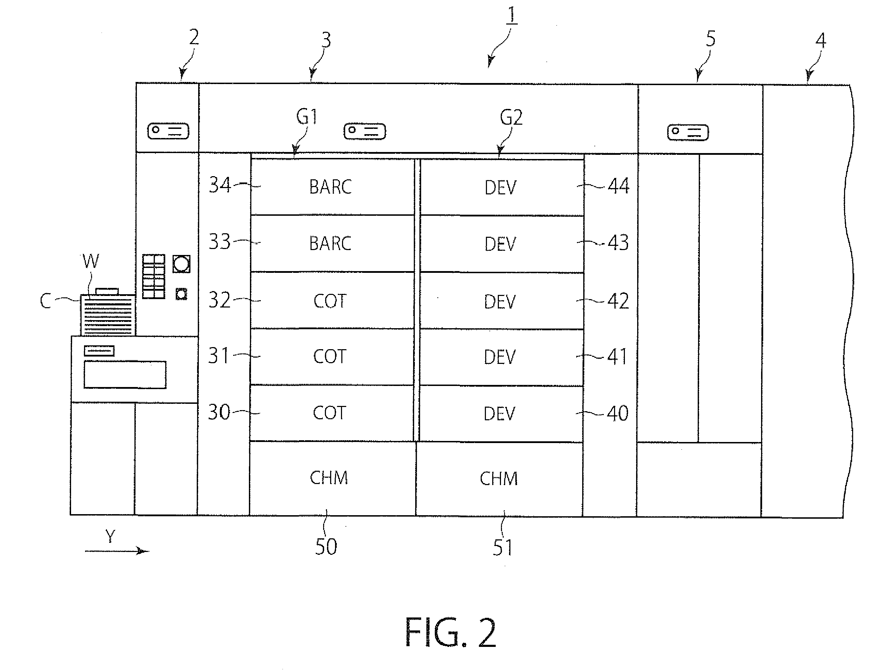

As shown in Fig. 2, the first processing unit group G1 includes a liquid processing unit that supplies a predetermined liquid to a wafer W to conduct processing, for example, resist coating units 30, 31, and 32 as the coating apparatus, and bottom coating units 33 and 34 that form antireflection film for preventing the reflection of light during an exposure process, those units being stacked successively in five stages from the bottom. The second processing unit group G2 includes liquid processing units, for example, developing units 40 to 44 for supplying a developer to the wafer W to conduct a developing process, those devices being stacked successively in five stages from the bottom. Further, chemical chambers 50 and 51 for supplying various kinds of processing liquids to the liquid processing unit in each of the processing unit groups G1 and G2 are disposed at the lowermost stages of the first processing unit group G1 and second processing unit group G2, respectively.

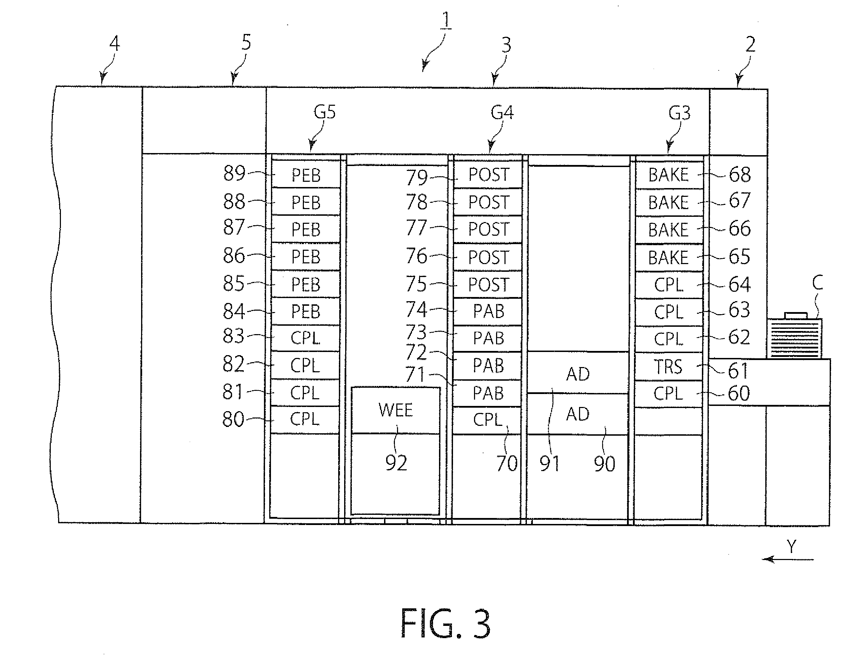

For example, as shown in Fig. 3, the third processing unit group G3 includes a temperature control unit 60 for placing the wafer W on its temperature control plate to control the temperature of the wafer W, a transition unit 61 for transferring the wafer W, temperature control units 62 to 64, and heat treatment units 65 to 68 for heating the wafer W, those units being stacked successively in nine stages from the bottom.

In the fourth processing unit group G4 includes processing units, for example, a temperature control unit 70, prebaking units 71 to 74 for heat treating the wafer W after the resist coating process, and post baking units 75 to 79 for heat treating the wafer W after the developing process, those units being stacked successively in ten stages from the bottom.

In the fifth processing unit group G5 includes a plurality of heat processing units for heat treating the wafer W, for example, temperature control units 80 to 83, and post-exposure baking units 84 to 89 for heat treating the wafer W after exposure, those units being stacked successively in ten stages from the bottom.

As shown in Fig. 1, a plurality of processing units are disposed on the positive X direction side of the first transfer device 20. For example, as shown in Fig. 3, adhesion units 90 and 91 for hydrophobizing the wafer W are stacked successively in two stages from the bottom. As shown in Fig. 1, for example, an edge exposure unit 92 for exposing only the edge portion of the wafer W is disposed on the positive X direction side of the second transfer device 21.

For example, as shown in Fig. 1, a wafer conveyer 101 that moves on a conveying path 100 extending in X direction, and a buffer cassette 102 are disposed on the interface station 5. The wafer conveyer 101 is movable in Z direction and also rotatable in θ direction. The wafer conveyer 101 can convey the wafer W while accessing the exposure apparatus 4 adjacent to the interface station 5, the buffer cassette 102 and each of the units in the fifth processing unit group G5.

The exposure apparatus 4 in this embodiment is an immersion exposure apparatus and can expose a resist film on the surface of the wafer W through a liquid film, e.g., a liquid film of pure water, while the liquid film is staying on the surface of the wafer W. However, the exposure apparatus 4 may be configured to conduct an exposure process of another type. The configuration of the resist coating and developing system is not restricted to the illustrated embodiment, but any other configuration that is capable of performing various processing for coating and development of the resist to be described in the present specification can also be adopted.

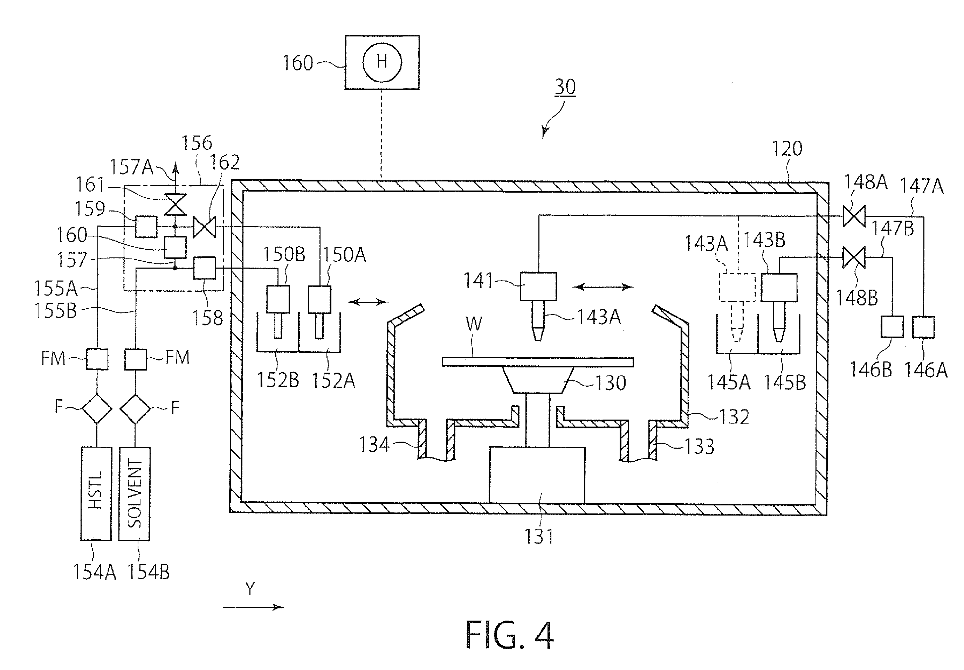

Then, the configurations of the resist coating units 30 to 32 will be described with reference to Figs. 4 to Fig. 5. Since the configurations of the resist coating units 30 to 32 are substantially identical with each other, the configuration of the resist coating unit 30 will be described, representing these units.

For example, as shown in Fig. 4, the resist coating unit 30 has a casing 120, and a spin chuck 130 as a rotary holding member for holding and rotating a wafer W is disposed to a central portion in the casing 120. The spin chuck 130 has a horizontal upper surface and, for example, suction holes (not illustrated) for suctioning the wafer W are disposed in the upper surface. The wafer W can be held on the spin chuck 130 by the suction from the suction holes.

The spin chuck 130 includes a chuck driving mechanism 131 having, for example, a motor, and can rotate at a predetermined speed by the chuck driving mechanism 131. Further, the chuck driving mechanism 131 is provided with a lift driving source, for example, a cylinder, and the spin chuck 130 can, therefore, move vertically. Further, the rotation speed of the spin chuck 130 is controlled by a control section 160 to be described later.

A cup 132 is disposed around the spin chuck 130 to receive and recover a liquid scattering or dropping from the wafer W. The lower surface of the cup 132 is connected with a discharge pipe 133 for discharging the recovered liquid and an exhaust pipe 134 for exhausting the atmosphere in the cup 132.

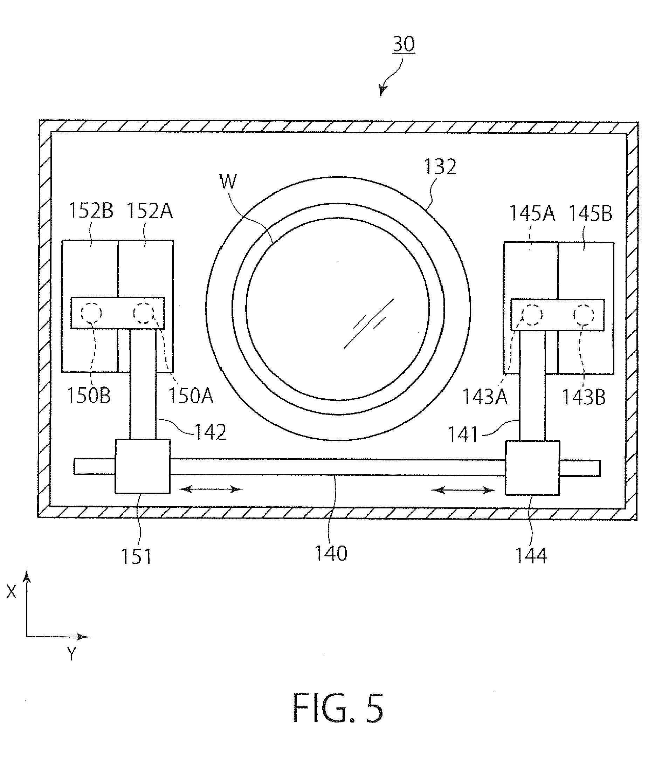

As shown in Fig. 5, on the negative X direction side (downward direction in Fig. 5) of the cup 132, a rail 140 extends along Y direction (in the rightward and leftward direction in Fig. 5). The rail 140 extends, for example, from a position outside the cup 132 on the negative Y direction side (in the leftward direction in Fig. 5) to a position outside the cup 132 on the positive Y direction side (in the rightward direction in Fig. 5). Two arms 141 and 142 are attached to the rail 140.

The first arm 141 supports a first resist nozzle 143A for discharging a first resist solution and a second resist nozzle 143B for discharging a second resist solution. The first arm 141 can move on the rail 140 by a nozzle driving device 144 shown in Fig. 5. Thus, the resist nozzles 143A and 143B can move from respective stand-by stations 145A and 145B disposed outside the cup 132 on the positive Y direction side of the cup 132 to a position above the central portion of the wafer W within the cup 132, and move on the surface of the wafer W in the radial direction of the wafer W. The first arm 141 can also be lifted by the nozzle driving device 144 and adjust the height of the resist nozzles 143A and 143B. A resist nozzle moving mechanism is constituted by the first arm 141 and the nozzle driving device 144.

As shown in Fig. 4, the first resist nozzle 143A is connected to a first supply pipe 147A in communication with a first resist solution supply source 146A. Further, the second resist nozzle 143B is connected to a second supply pipe 147B in communication with a second resist solution supply source 146B. For example, resist A for ArF liquid immersion exposure having a surface tension of 28.8 [mN/m] is stored as a first resist solution in the first resist solution supply source 146A. For example, the first resist solution is controlled to have a low viscosity (for example, 2cp or less) for forming a thin resist film, for example, a resist film of 150 nm thickness or less.

A second resist solution having a surface tension different from that of the first resist solution is stored in the second resist solution supply source 146B. The second resist solution may have resist components identical with those of the first resist solution and have a surface tension different from that of the first resist solution due to the difference of the solvent content. Alternatively, the second resist solution may have resist components different from those of the first resist solution.

Valves 148A and 148B are disposed in the first and second supply pipes 147A and 147B, respectively, and the resist solutions from the first and second resist nozzles 143A and 143B can be discharged or stopped being discharged by the opening and closing of valves 148A and 148B.

When the surface of the wafer is coated with two or more kinds of resist solutions having identical resist components and different only in the viscosity, only one resist nozzle may be provided. In this case, the resist can be supplied to the one resist nozzle through a solvent content control mechanism (for example, a mixer capable of varying the mixing ratio) connected to a resist solution reservoir and a solvent reservoir. "The surface tension of the resist solution" in the present specification means the surface tension of the resist solution as a whole. If the content of the solvent contained in the resist solution changes, the surface tension of the resist solution, of course, also changes.

The second arm 142 supports a first prewetting nozzle 150A and a second prewetting nozzle 150B. The second arm 142 is movable on the rail 140 by a nozzle driving device 151 shown in Fig. 5. Thus the prewetting nozzles 150A and 150B can move from each of stand-by stations 152A and 152B disposed outward of the cup 132 on the negative side in the direction Y of the cup 132 to a position above the central portion of the wafer W in the cup 132. Further, the second arm 142 can be lifted by the nozzle driving device 151 and can control the height of the prewetting nozzles 150A and 150B. A resist nozzle moving mechanism is constituted by the second arm 142 and the nozzle driving device 151.

A prewetting liquid is supplied to the first and second prewetting nozzles 150A and 150B by a prewetting liquid supply mechanism. The prewetting liquid supply mechanism has a supply source 154A for a high surface tension liquid (HSTL), and a supply source (solvent supply source) 154B for a solvent capable of dissolving a resist (hereinafter also referred to as "resist dissolving solvent") (SOLVENT). "Resist dissolving solvent" is not limited to an ordinary solvent that is contained in an ordinary resist solution for dissolving the resist components, but may be selected from various solvent capable of dissolving the resist component. The high surface tension liquid has a surface tension higher than that of the resist dissolving solvent and, in this sense, this is referred to as "high" surface tension solution in the present specification. The resist dissolving solvent may be, for example, OK73 (mixed solution of propylene glycol monomethyl ether (PGME) and propylene glycol monomethyl ether acetate (PGMEA) (7:3 mixing ratio); surface tension of 27.7 mN/m, manufactured by Tokyo Ohka Kogyo Co., Ltd.) and CHN (cyclohexanone, surface tension of 33.5 mN/m). Fluids having a surface tension higher than that of OK73 may be, for example, DIW (pure water) and GBL (γ-butyrolactone). The high surface tension liquid supply source 154A is connected through a first line 155A to the first prewetting nozzle 150A. The solvent supply source 154B is connected through a second line 155B to the second prewetting nozzle 150B.

The prewetting liquid supply mechanism further has a supply control section 156 for controlling the state of supplying the prewetting liquid from the first and second prewetting nozzles 150A and 150B. The supply control section 156 has a connection line 157 for connecting the first line 155A and the second line 155B, a valve 158 interposed in the second line 155B at the downstream of the connection point to the connection line 157, a valve 159 interposed in the first line 155A at the upstream of the connection point to the connection line 157, and a valve 160 interposed in the connection line 157. Further, the connection line 157 extends beyond the connection point at which the connection line 157 is connected with the first line 155A to form a drain line 157A, and the drain line 157A is in communication with a not illustrated drain section. A valve 161 is interposed in the drain line 157A. Preferably, the valves 158, 159, 160, and 161 are automatic air operation valves and controlled by a control section 160, described later. The valves 158, 159, and 160 are valves having a flow rate control function in addition to the opening/closing function and are, preferably, automatic air operation valves. The valves 160 and 161 may also be shutoff valves having only the opening/closing function. Further, in the prewetting liquid supply mechanism shown in Fig. 4, F denotes a filter and FM denotes a flow meter.

As apparent from the configuration shown in Fig. 4, a state where a prewetting liquid comprising a mixed liquid of the resist dissolving solvent and the high surface tension liquid is supplied from the first prewetting nozzle 150A, and a state where a prewetting liquid only consisting of the resist dissolving solvent is supplied from the second prewetting nozzle 150B can be attained selectively in the prewetting liquid supply mechanism. That is, by closing the valves 160, 161, and 162 and opening the valve 158, the resist dissolving solvent can be supplied as the prewetting liquid from the second prewetting nozzle 150B to the wafer W. Further, by closing the valves 158 and 161, opening the valve 162 and opening the valves 159 and 160 each at an appropriate opening degree, a mixed liquid of the resist dissolving solvent and the high surface tension liquid mixed at a desired mixing ratio can be supplied as the prewetting liquid to the wafer W. The valve 161 on the drain line 157A can be used for discharging the mixed liquid remaining in the portion of the supply control section 156 to the drain when it is intended to change the mixing ratio of the mixed liquid for example.

It should be noted that the wordings "first" and "second" assigned to the names of the elements used for supplying the prewetting liquid do not sometimes conform to the recitations in the claims.

The relation between the nozzles and the arms is not limited to that illustrated in the drawing. For example, the first resist nozzle 143A and the second resist nozzle 143B may be supported by separate arms. Further, the first prewetting nozzle 150A and the second prewetting nozzle 150B may be supported by separate arms. All of the nozzles may be supported by a common arm.

The control section 160 controls the rotational operation of the spin chuck 130, the moving operation of the resist nozzles 143A and 143B by the nozzle driving device 144, the discharging operation of the resist solution from the resist nozzles 143A and 143B by the valves 148A and 148B, the moving operation of the first and second prewetting nozzles 150A and 150B by the nozzle driving device 151, and the discharging operation of the prewetting liquid from the first and second prewetting nozzles 150A and 150B by the valves 158 to 162 as described above. The control section 160 includes, for example, a computer having CPU, a memory, etc, and can realize the resist coating process in the resist coating unit 30 by executing programs stored in the memory, for example. Various programs for realizing the resist coating process in the resist coating unit 30 are ones stored in a storage medium H such as CD (compact disc) that can be read by a computer and installed from the storage medium H to the control section 160, for example.

The coating process performed by the resist coating unit 30 will described in connection with the whole processes to the wafer performed in the coating and developing system 1.

First, as shown in Fig. 1, unprocessed wafers W are taken out one by one from the cassette C on the cassette mounting stage 10, and then conveyed successively to the processing station 3. The wafer W is conveyed to the temperature control unit 60 belonging to the third processing unit group G3 of the processing station 3, and the wafer temperature is adjusted to a predetermined temperature. Then, the wafer W is conveyed by the first transfer device 20, for example, to the bottom coating unit 34, in which an antireflection film is formed. Subsequently, the wafer W is conveyed by the first transfer device 20, for example, to the heat treatment unit 65 and the temperature control unit 70 successively, and subjected to predetermined processing in each of the processing units. Then, the wafer W is conveyed by the first transfer device 20 to one of the plurality of resist coating units 30 to 32, for example, the resist coating unit 30.

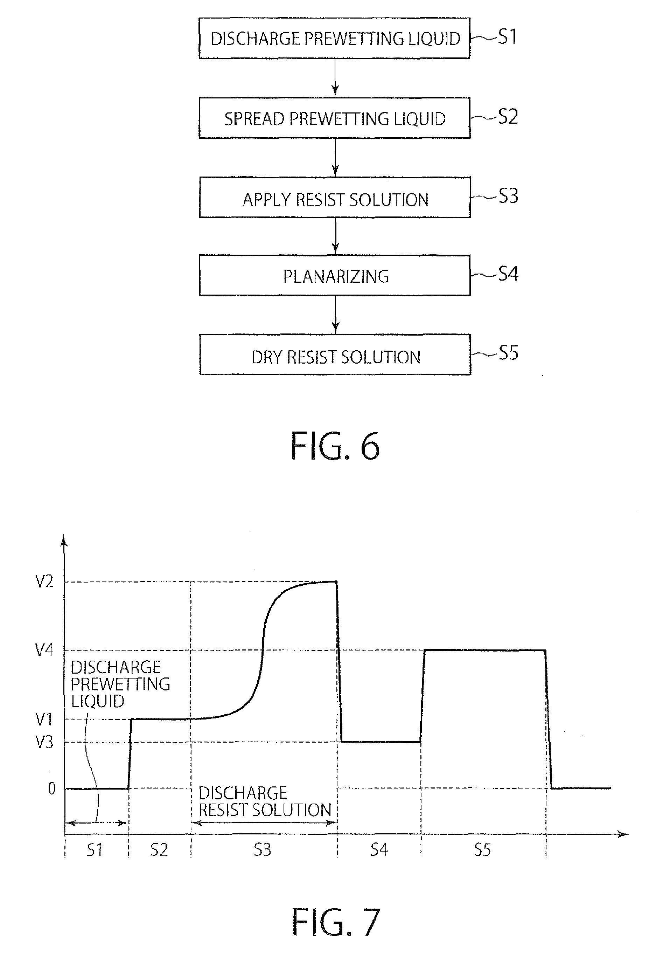

A series of steps of the coating process in the resist coating unit 30 will be described with reference to Figs. 6 and 7. Fig. 6 shows a flow chart showing main steps of the coating process in the resist coating unit 30. Fig. 7 shows a graph showing the rotation speed of the wafer W in each of the steps.

First, after conveyed into the resist coating unit 30, the wafer W is held by the spin chuck 130 by suctioning, as shown in Fig. 4.

It is assumed here that the resist solution to be coated is the resist A for ArF liquid immersion exposure, described above. The surface tension of the resist solution is 28.8 [mN/m]. Then, a resist dissolving solvent stored in the solvent supply source 154B is assumed as OK73, described above. The surface tension of OK73 is 27.7 [mN/m], which is lower than the surface tension of the resist solution. This is a situation where fingering is likely to occur, according to the principle which will be described in deteil later. In this case, a high surface tension liquid is mixed to OK73 to prepare a mixed liquid having a higher surface tension than OK73, which is supplied as a prewetting liquid to the wafer.

The first prewetting nozzle 150A at the stand-by station 152A is moved by the second arm 142 to a position above the central portion of the wafer W. Then, the valve 162 is opened, and the valves 159 and 160 are opened to a predetermined opening degree with the valves 158 and 161 closed. The opening degree for the valves 159 and 160 are adjusted such that the resultant surface tension of the mixed liquid is an appropriate value, for example, of 30.4 [mN/m], which is higher than the surface tension of the resist solution, 28.8 [mN/m]. The mixing ratio of the resist dissolving solvent and the high surface tension liquid is previously determined in a processing recipe, based on the result of experiments as shown in experimental examples to be described later, and the coating units 30 to 32 can be adapted such that the control section 160 automatically controls the prewetting liquid supply control section 156 based on the processing recipe.

In a state where the wafer W is stopped, the prewetting liquid comprising the foregoing mixed liquid is supplied from the first prewetting nozzle 150A to the central portion of the wafer by a predetermined amount (prewetting liquid discharge step S1 in Fig. 6). As shown in Fig. 7, the wafer W is rotated by the spin chuck 130 at a first speed V1, for example, of about 500 rpm and the prewetting liquid on the wafer W spreads over the whole surface of the wafer W to bring the whole surface of the wafer W to be wetted by the prewetting liquid (prewetting liquid spreading step S2 in Fig. 6). During the prewetting liquid spreading step S2, the first prewetting nozzle 150A is withdrawn from a position above the wafer W and the first resist nozzle 143A at the stand-by station 145A is moved by the first arm 141 to a position above the central portion of the wafer W.

Thereafter, the valve 148A is opened to start the discharge of the resist solution from the first resist nozzle 143A as shown in Fig. 7 and the supply of the resist solution to the central portion of the wafer W. Thus, the resist solution coating step S3 (first stage in the resist film forming step) is started. In the resist solution coating step S3, the rotation speed of the wafer W is increased from the first speed V1 to a second speed V2 at a higher speed, for example, of about 2000 to 4000 rpm. The rotation speed of the wafer W, which is the first speed V1 before starting the resist solution coating step S3, is thereafter gradually accelerated such that the rotation speed is continuously smoothly changed. In this step, the acceleration of the rotation of the wafer W is gradually increased, for example, from zero. Then, toward the end of the resist solution coating step S3, the acceleration of the rotation of the wafer W is gradually decreased and the rotation speed of the wafer W is smoothly settled to the second speed V2. Thus, in the resist solution coating step S3, the rotation speed of the wafer W changes from the first speed V1 to the second speed V2 so as to trace an S-shaped curve on the graph in Fig. 7. In the resist solution coating step S3, the resist solution supplied to the central portion of the wafer W spreads over the whole surface of the wafer W by the centrifugal force, and the surface of the wafer W is coated with the resist solution.

The discharge of the resist solution by the first resist nozzle 143A in the resist solution coating step S3 may be continued until a point of time during the below-mentioned planarizing step S4. Further, when the discharge of the resist solution is terminated, the first resist nozzle 143A may be moved to displace the discharging position of the resist solution from the central portion of the wafer W.

When the resist solution coating step S3 is continued for a predetermined time and then terminated, the rotation of the wafer W is decelerated to a slow speed, for example, a third speed V3 of about 300 rpm as shown in Fig. 7, so that the resist solution on the wafer W is smoothed and planarized (planarizing step S4 in Fig. 6 (second stage in the resist film forming step)).

When the planarizing step S4 is continued for a predetermined time and then terminated, the rotation of the wafer W is accelerated to a medium speed, for example, to a fourth speed V4 of about 1500 rpm as shown in Fig. 7, so that the resist solution on the wafer W is dried (drying step S5 in Fig. 6 (third stage in the resist film forming step)). Thus, a thin resist film (photoresist film) is formed on the wafer W.

After completion of the drying of the wafer W, the rotation of the wafer W is stopped. The wafer W is then removed from the spin chuck 130, and a series of steps of the resist coating process is completed.

After the resist coating process, the wafer W is conveyed by the first transfer device 20, for example, to the prebaking unit 71, in which the wafer W is prebaked. Next, the wafer W is conveyed by the second transfer device 21 to the edge exposure unit 92 and the temperature control unit 83 successively, and subjected to predetermined treatments in the respective units. Then, the wafer W is conveyed by the wafer conveyer 101 of the interface station 5 to the exposure apparatus 4, and subjected to immersion exposure. Thereafter, the wafer W is conveyed by the wafer conveyer 101, for example, to the post-exposure baking unit 84, in which the wafer W is subjected to post-exposure baking. After that, the wafer W is conveyed by the second transfer device 21 to the temperature control unit 81, in which the temperature of the wafer W is adjusted. Then, the wafer W is conveyed to the developing unit 40, in which the resist film on the wafer W is developed. After the development, the wafer W is conveyed by the second transfer device 21 to the post-baking unit 75 in which the wafer is subjected to post-baking. Thereafter, the wafer W is conveyed by the first transfer device 20 to the temperature control unit 63, in which the temperature of the wafer W is controlled. Then, the wafer W is conveyed by the first transfer device 20 to the transition device 61 and returned by the wafer conveyer 12 to the cassette C. A series of steps of the wafer processing is thus completed.

It may be considered that, depending on the processing schedule of the coating and developing system, after coating a certain wafer W with a first resist solution (resist A for ArF solution immersion exposure at a surface tension of 28.8 [mN/m] in the foregoing embodiment) by using the first resist nozzle 143A, another wafer W is coated with a second resist solution different from the first resist solution by using the second resist nozzle 143B. The overall flow of the coating processes for the first resist solution and the second resist solution may be the same. In this case, if the surface tension of the second resist solution is lower than the surface tension of the first resist solution, a prewetting liquid comprising a mixed liquid having a low content of the high surface tension liquid, determined based on the surface tension difference between the second resist solution and OK73, may be supplied from the first prewetting nozzle 150A. Alternatively, a prewetting liquid, which is composed only of OK73 and which is not mixed with the high surface tension liquid, may be supplied from the second prewetting nozzle 150B. Also, when the surface tension of the second resist solution is higher than the surface tension of the first resist solution, a prewetting liquid comprising a mixed liquid having a high content of the high surface tension liquid, determined based on the surface tension difference between the second resist solution and OK73, may be supplied from the first prewetting nozzle 150A.

According to the foregoing embodiment, the rotation of the wafer W that has rotated at the first speed V1 before the start of the resist solution coating step S3 is gradually accelerated such that the rotation speed changes continuously after the start of the step S3. The acceleration of the rotation of the wafer W is gradually decreased and the rotation of the wafer W is converged or settled to the second speed V2 upon the completion of the step S3. Coating spots can therefore be suppressed even when the wafer W is coated with a small amount of the resist solution. Accordingly, the amount of the resist solution used can be decreased and a thinner film can be formed. Further, the cost can be saved. It has been experimentally confirmed that the amount of the resist used can be decreased by about 10% by changing the rotation speed of the wafer as described above.

If the rotation speed of the wafer W is increased sharply upon the discharge of the resist so as to rotate the wafer W at a high speed from the initial period like the conventional method, a strong centrifugal force exerts on the resist solution PR just after the supply of the resist solution R to the central portion of the wafer W. Therefore, the resist solution R spreads irregularly outward and the fingering is likely to occur particularly when the amount of the resist solution R is small, In contrast, with the foregoing embodiment, as the rotation speed of the wafer W is controlled so as to trace an S-shaped form, the rotation speed of the wafer W is low and does not change so much, immediately after the supply of the resist solution to the central portion of the wafer W. Thus, a strong centrifugal force does not exert on the resist solution R and the resist solution PR spreads outward uniformly. Further, the rotation speed of the wafer W continuously changes thereafter, so that the resist solution PR on the wafer W spreads smoothly. The above is considered to be the reasons why the fingering does not occur even when the amount of the resist solution is small.

The foregoing resist-saving technique using the change of the wafer rotation speed during the resist coating is specifically described in JP2009-078250A (Publication of Japanese Patent Application No. 2007-251056), corresponding to US2009/0087559A1, in which some of the inventors and the assignee (applicant) are in common with those of the present application. Therefore, no further explanation is made in the present specification.

Further, according to the foregoing embodiment, the possibility of the occurrence of the fingering can be reduced remarkably under the conditions where the amount of supply of the resist solution is identical and the wafer rotation speed (particularly the second speed V2) is identical, by using the prewetting liquid having a surface tension higher than that of the resist solution. As a result, a thin and uniform resist film can be formed with a small amount of the resist solution. By the combination of the foregoing technique for changing the rotation speed of the wafer and the technique for controlling the surface tension of the prewetting liquid, the consumption of the resist solution can be further reduced. The consumption of the resist solution can be greatly reduced by about 60 to 70% by employing the technique for controlling the surface tension of the prewetting liquid, while it depends on the conditions.

Since the reduction of the resist solution consumption achieved by the use of the technique for controlling the surface tension of the prewetting liquid is very large, the combined use of the technique for controlling the surface tension of the prewetting liquid and the technique for changing the rotation speed of the wafer is preferred. However, it may be considered that they are not used in combination in some cases.

The inventors consider the reason that the advantageous effect can be obtained by controlling the surface tension of the prewetting liquid is as follows.

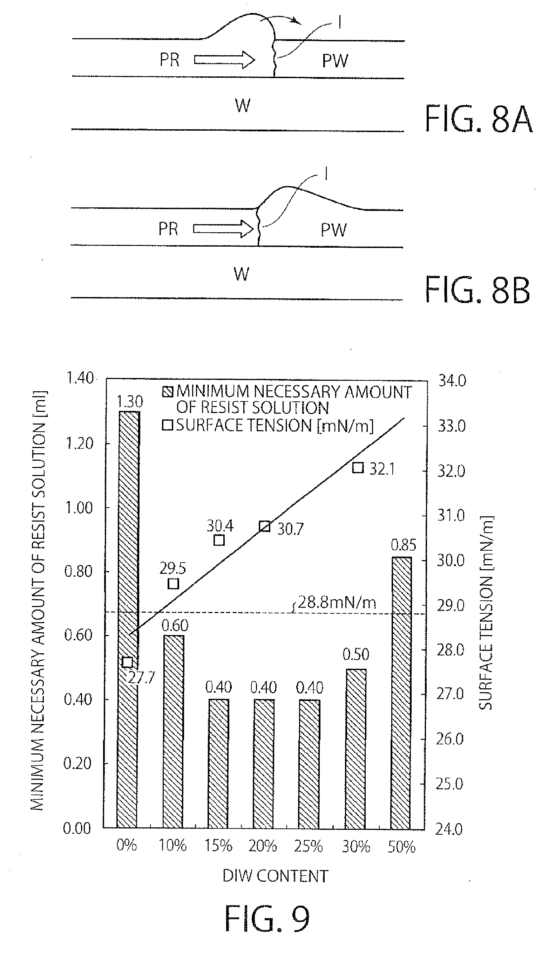

Fig. 8A schematically shows a state of an interface I between a resist solution PR and a prewetting liquid PW spreading radially outwardly by a centrifugal force shown by a blank arrow, when the surface tension of the resist solution PR is higher than the surface tension of the prewetting liquid PW. (Note that, since the resist solution PR and the prewetting liquid PW are dissolved in each other near the boundary therebetween, no distinct interface is present. However, for the convenience of the explanation, the wording "interface I" is used herein). In this case, the resist solution PR rises before the interface I due to the difference of the surface tension. Then, the raised portion of the resist solution PR that undergoes a (radially outward) centrifugal force locally overrides the interface I between the resist solution PR and the prewetting liquid PW anywhere in the circumferential direction of the wafer, and proceeds onto the surface of the liquid film of the prewetting liquid PW as indicated by a solid arrow. It is considered that the fingering is generated by such behavior.

The phenomenon as shown in Fig. 8A occurs, for example, in a specific combination of a resist A for ArF liquid immersion exposure having a surface tension of 28.8 [mN/m] as the resist solution and OK73 having a surface tension of 27.4 [mN/m] as the prewetting liquid. In this case, the resist solution must be supplied at least by about 0.60 mL to prevent the occurrence of the fingering even when the coating recipe is optimized (specifically, control of the coating timing of the resist solution, wafer rotation speed, etc.).

On the contrary, when the surface tension of the prewetting liquid PW is higher than that of the resist solution PR, the prewetting liquid PW rises near the interface as shown in Fig. 8B. Since the raised portion of the prewetting liquid PW undergoes a (radially outward) centrifugal force in this case, it does not override the interface I between the prewetting liquid PW and the resist solution PR and moves radially outwardly as it is. It is, accordingly, considered that the above is the reason why fingering does not occur. In this state, the resist uniformly diffuses concentrically from the central portion to the peripheral portion of the wafer.

The phenomenon as shown in Fig. 8B occurs, for example, in a specific combination of a resist A for ArF liquid immersion exposure having a surface tension of 28.8 [mN/m] as the resist solution and CHN having a surface tension of 33.5 [mN/m] as the prewetting liquid. In this case, when the coating recipe is optimized, the fingering does not occur if the resist solution is supplied at least by about 0.25 to 0.35 mL. Of course, in a case where a prewetting liquid whose surface tension is adjusted as described in connection with the foregoing embodiments, the phenomenon as shown in Fig. 8B occurs.

When the surface tensions of the resist solution and the prewetting liquid are substantially identical, no remarkable raise like what described above occurs on both the resist solution side and the prewetting liquid side. However, the fingering is likely to occur more in this state compared with the state where the surface tension of the resist solution is lower than that of the prewetting liquid. Such a state occurs, for example, in a specific combination of an ArF dry resist solution (for usual exposure, not for immersion exposure) and an OK73 prewetting liquid. In this case, if the coating recipe is optimized and the resist solution is supplied at least by about 0.35 to 0.40 mL, fingering does not occur.

Note that, if a sufficient large amount of a resist solution is supplied, the fingering does not occur irrespective of the relation between the surface tensions of the resist solution and the prewetting liquid. It is estimated that the resist solution uniformly overrides the interface between the resist solution and the prewetting liquid if the amount of the resist solution is sufficiently large even when the phenomenon as shown in Fig. 8A should occur.

In view of the above, it is certain that the surface tension of the prewetting liquid is preferably higher than the surface tension of the resist solution to prevent the occurrence of the fingering. The level by which the surface tension of the prewetting liquid is higher than that of the resist solution must be decided in consideration of various conditions such as the target discharge amount of the resist solution, the coating recipe, the composition of the resist solution, the composition of the prewetting liquid, the composition of the high surface tension liquid, etc.

### [Example]

Advantageous effects of the invention are to be described with reference to specific experimental examples.

### [Experimental Example 1]

12-inch wafers W were used in the experiment. The previously-described resist A for ArF immersion exposure (surface tension: 28.8 [mN/m]) was used as a resist solution, OK73 (surface tension: 27.7 [mN/m]) was used as a resist dissolving solvent, and DIW (surface tension: about 72 [mN/m]) was used as a high surface tension liquid. The prewetting liquid and the resist solution were supplied according to the procedures which are identical with those of the preferred embodiment explained with reference to Fig. 7. The second speed V2 in the resist coating step S3 was set at 2000 rpm. Prewetting liquids having DIW content (DIW amount/(OK73 amount + DIW amount) (volume ratio)) of 0%, 10%, 15%, 20%, 25%, 30%, 50%, and 100% respectively were prepared. The supply amount of the prewetting liquid was 2.5 mL. The discharge amount of the resist solution was increased step by step to examine the minimum discharge amount of the resist solution allowing the wafer to be well coated with resist solution, for every DIW content.

The graph in Fig. 9 shows the result of the examination. The abscissa in the graph shows the DIW content, the left ordinate in the graph shows the minimum discharge amount of the resist solution allowing the wafer W to be well coated (indicated by vertical bars in the graph), the right ordinate in the graph shows the surface tension of the prewetting liquid corresponding to the DIW content (indicated by blank squares in the graph). As apparent from the graph in Fig. 9, it was confirmed that most preferred coatability was achieved at the DIW content of from 15 to 25%, in which the discharge amount of the resist solution could be decreased to as small as 0.40 mL. At the DIW content of 10% or more, the surface tension of the prewetting liquid was higher than that of the resist solution. Further, it was confirmed that the surface tension of the prewetting liquid increases substantially linearly with the increase of the DIW content. This means that the DIW content necessary for obtaining the prewetting liquid having a desired surface tension can be determined easily by calculation.

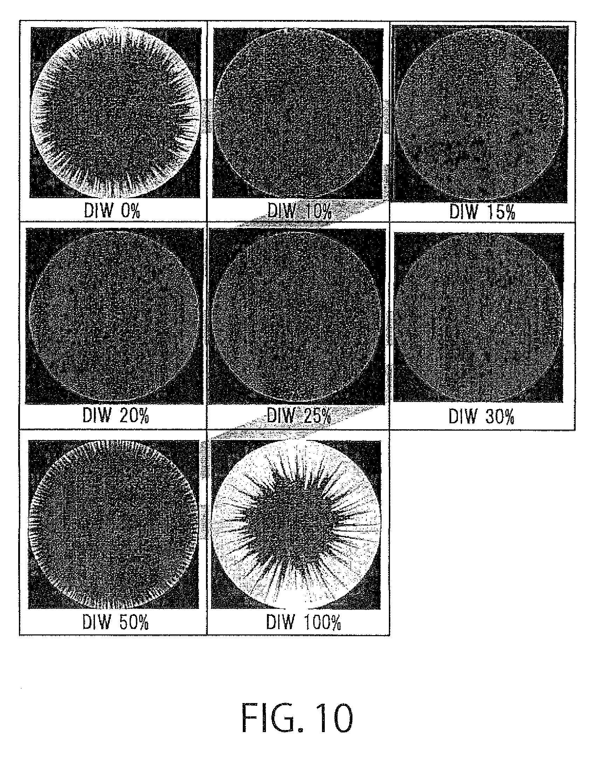

Fig. 10 is a copy of photographs showing the results of the resist coating corresponding to the DIW content of 0%, 10%, 15%, 20%, 25%, 30%, 50% and 100%, respectively, while the discharge amount of the resist solution was kept constant at 0.40 mL. At the DIW content of 0%, fingering was remarkable and, at the DIW content of 10%, fingering was slightly observed at the outermost circumference of the wafer. At the DIW content of 15%, 20%, and 25%, fingering was not observed at all. At the DIW content of 30%, fingering was slightly observed at the outermost circumference of the wafer and, at the DIW content of 50%, fingering was observed distinctly. At the DIW content of 100%, severe fingering was observed.

The reason why fingering occurred as the DIW content was excessively high is considered as below. It is considered that, when the content of DIW as the high surface tension liquid becomes excessively high so that the surface tension of the prewetting liquid becomes excessively high, the behavior of the prewetting liquid and the resist solution at the interface therebetween may become instable. Specifically, it may be considered, for example, that when the prewetting liquid PW rises excessively, the raised portion may be collapsed and moved to the resist solution PR thereby impairing the uniformity of the resist solution. Further, it is considered that, when a high surface tension fluid with little compatibility with the resist solution such as DIW is used, if the content of the high surface tension liquid is excessively high, the prewetting effect expected on the basis of the compatibility is lost. Accordingly, it is considered that an optimal range of the mixing ratio between the resist dissolving solvent and the high surface tension liquid changes depending on the type of the resist solution, the resist solution coating condition, and the type of the resist dissolving solvent and the high surface tension liquid.

### [Experimental Example 2]

A test was performed for examining the coatability of the resist solution with and without the surface tension control of the prewetting liquid. Prewetting liquids were prepared by mixing DIW with OK73 to have the DIW content (DIW amount/(OK73 amount + DIW amount) (volume ratio)) of 0% (comparative examples) and 20% (examples), respectively. In the resist solution coating step S3, the second speed V2 was set to 2000 rpm, 3000 rpm, and 4000 rpm. Other conditions were identical with those in Experimental Example 1. The discharge amount of the resist solution was increased step by step from 0.3 mL, and the minimum discharge amount of the resist solution capable of preventing occurrence of the fingering was examined for each second speed V2.

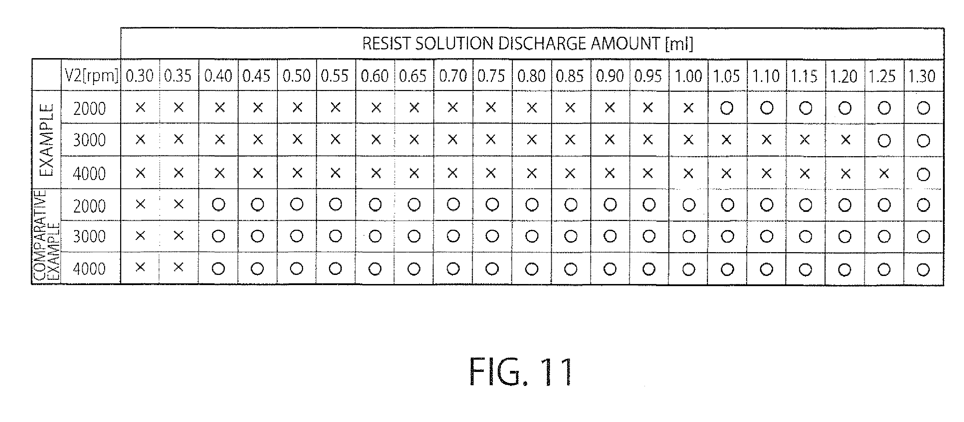

The result of the examination is shown in the table of Fig. 11. In the table, "○" means the whole surface of the wafer was coated uniformly without fingering; "×" means that fingering occurred. In the examples, fingering did not occur and the wafer surface could be uniformly coated when the discharge amount of the resist solution was at least 0.4 mL irrespective of the second speed V2. On the contrary, in the comparative examples, the discharge amount of the resist solution needs to be at least 1.05 mL for preventing the occurrence of the fingering and, in addition, the necessary discharge amount of the resist solution for preventing fingering was increased as the second speed V2 became higher.

### [Experimental Example 3]

The study was made also on other combinations of the resist dissolving solvent and the high surface tension liquid.
Two types, that is, OK73 and CHN (surface tension: 33.5 mN/m) were used as the resist dissolving solvent, and GBL (surface tension: about 45 mN/m) was used as the high surface tension liquid. Also CHN is a substance that is relatively frequently used as the solvent for the resist, and can be used per se as the prewetting liquid.

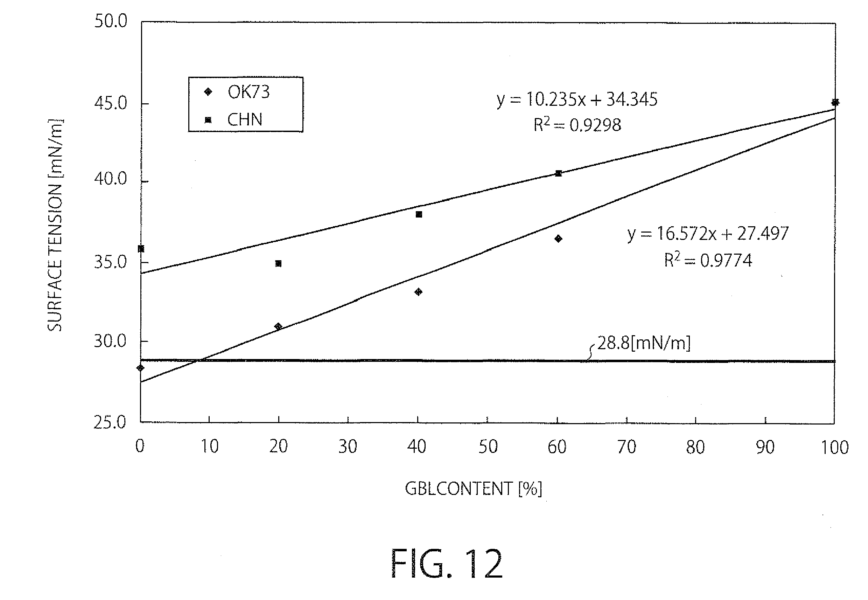

GBL was mixed with each of the resist dissolving solvents (OK73 and CHN) to have a GBL content (GBL amount/(solvent amount + GBL amount), volume ratio) was 0%, 20%, 40%, 60%, and 100%, respectively. The change of the surface tension of the mixed liquid relative to the change of the GBL content was examined. The result is shown in the graph of Fig. 12. With both the two resist dissolving solvents, the surface tension increases relatively linear with the increase of the GBL content. It was confirmed that in both cases linear approximation can be done with a sufficient reliability (R square value is 0.9 or more). This means that the GBL content necessary for obtaining a prewetting liquid having a desired surface tension can be determined easily by calculation.

As apparent from the graph in Fig. 12, since the surface tension of CHN (33.5 mN/m) is higher than that of the resist A for ArF immersion exposure (28.8 [mN/m]), CHN can be used individually when the resist solution is a resist A for ArF liquid immersion exposure. However, it is considered that mixing of GBL with CHN is effective when a resist solution having a higher surface tension than the resist A for ArF immersion exposure is used.

### [Effect of the Embodiments]

According to the surface tension controlling technique for the prewetting liquid, the following advantageous effects can be obtained.
(1) The surface tension of the prewetting liquid is controlled so as to be higher than the surface tension of the resist solution, so that the occurrence of fingering can be suppressed effectively. Thus, a uniform resist film can be prepared even with a small amount of the resist solution.
(2) Prewetting liquids suitable for various resist solutions can be prepared in-situ easily, by separately providing one type of a resist dissolving solvent and one type of a high surface tension liquid, and by mixing the resist dissolving solvent and the high surface tension liquid at an appropriate mixing ratio, when the prewetting liquid is supplied. Thus, it is no longer necessary to previously prepare prewetting liquids having various surface tensions and, thus, it is no longer necessary to provide a number of processing solution storing sections in a coating unit (apparatus).
(3) The advantage shown in (2) above is particularly remarkable when one coating unit (apparatus) is adapted to coat various types (for example, three types or more) of resist solutions. In the embodiment described above, in addition to the first and second resist nozzles for discharging the first resist solution and the second resist solution respectively, one or a plurality of other resist nozzles, for example, a third resist nozzle for discharging a third resist solution can, of course, be provided.
(4) When DIW is used as the high surface tension liquid, surface tension control can be conducted at a low cost. Further, since DIW is used for various units in a coating and developing system, it is not necessary to provide a DIW supply source used exclusively for the supply of the high surface tension liquid.
(5) Burden on a user using the unit (apparatus) can be reduced. For example, for a user who uses OK73 as a prewetting liquid in principle, if OK73 is intended to be replaced with other prewetting liquids, for example, CHN, steps for changing the liquid and steps of quality confirmation test necessary for the replacement of the liquid become necessary. On the contrary, when the surface tension is controlled by the addition of the high surface tension liquid, user's burden is considerably reduced in that there is no requirement of replacing the basic prewetting liquid and in that the quality confirmation test can be conducted easily.
(6) By separately providing a nozzle for discharging a resist dissolving solvent not containing the high surface tension liquid as a prewetting liquid and a nozzle for discharging a mixed liquid of a resist dissolving solvent and a high surface tension solvent, as in the coating apparatus of the foregoing embodiment, a high-purity solvent for a resist not containing a high surface tension liquid can be supplied to the wafer.

The present invention is not limited to those described above in connection with the foregoing embodiments and experimental examples.

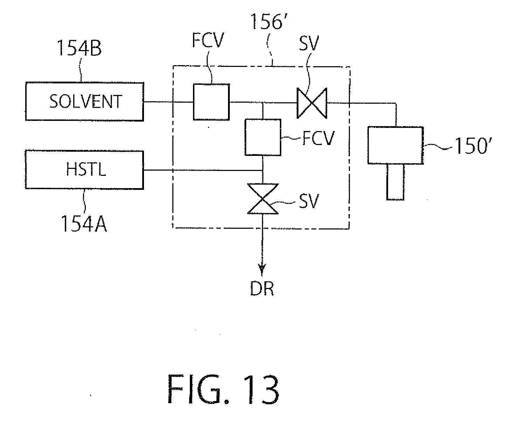

For example, the prewetting liquid supply mechanism may also be configured as shown in Fig. 13. That is, only one prewetting nozzle 150' is connected to a supply source 154B for a resist dissolving solvent and a supply source 154A for a high surface tension liquid through a mixing mechanism (prewetting liquid supply control section) 156', so that a prewetting liquid composed only of a resist dissolving solvent, or a prewetting liquid comprising a mixed liquid of a resist dissolving solvent and a high surface tension liquid (at variable mixing ratio) can be supplied to the prewetting nozzle 150'. In Fig. 13, reference FCV denotes a flow rate control valve, SV denotes a check valve, and DR denotes a drain. Solid lines connecting each of the components are lines through which fluids flow.

Further, if there is no problem even if the resist dissolving solvent and the high surface tension liquid are stored in a mixed state, a prewetting liquid can also be prepared by previously mixing the resist dissolving solvent and the high surface tension liquid before the prewetting liquid is supplied to a wafer.

In the foregoing embodiments, the coating solution is a resist solution but is not limited thereto. The coating technique according to the foregoing embodiments is applicable also to the coating of coating solutions other than the resist solution, for example, a coating solution forming an antireflection film, a coating solution forming an SOG (Spin On Glass) film, and a coating solution forming an SOD (Spin On Dielectric) film. Further, the target of the coating is not restricted to the wafer W and this may be substrates other than the wafer, for example, FPD (Flat Panel Display) and a mask reticle for a photomask.

The embodiments described above are useful in various coating treatments in the manufacture for semiconductor devices.

## Claims

1. A coating method comprising:
a prewetting step of supplying a prewetting liquid to the center of a first substrate and rotating the first substrate thereby spreading the prewetting liquid over the whole surface of the substrate; and
a coating film forming step of supplying a coating solution to the first substrate supplied with the prewetting liquid and drying the coating solution thereby forming a coating film on the surface of the first substrate;
the coating film forming step including:
a first stage in which the coating solution is supplied to a central portion of the first substrate while the first substrate is rotated;
a second stage in which rotation speed of the first substrate is then decreased and then the first substrate is continuously rotated; and
a third stage in which the rotation speed of the first substrate is then increased to dry the coating solution on the first substrate,
wherein, in the first stage, the first substrate is rotated at a first constant rotation speed (V1) immediately before the coating solution is supplied to the first substrate, then the rotation speed of the substrate is gradually increased continuously after starting of supply of the coating solution, and acceleration of the rotation of the first substrate is gradually decreased before completion of discharging of the coating solution, thereby converging the rotation speed of the substrate to a second rotation speed (V2) higher than the first rotation speed, and
**characterized in that**:
the prewetting liquid used in the prewetting step is a mixed liquid obtained by mixing a solvent capable of dissolving components of the coating film and a high surface tension liquid having a surface tension higher than that of the solvent, the mixed liquid having a surface tension higher than that of the coating solution.

2. The coating method according to claim 1, **characterized in that** the solvent and the high surface tension liquid are separately provided and the solvent and the high surface tension liquid are mixed when the prewetting liquid is supplied.

3. The coating method according to claim 1 or 2, **characterized in that**:
a prewetting step of supplying a prewetting liquid to the center of a second substrate and rotating the second substrate thereby spreading the prewetting liquid over the whole surface of the substrate; and
a coating film forming step of supplying, to the second substrate supplied with the prewetting liquid, a coating solution having a surface tension different from that of the coating solution supplied to the first substrate and drying the coating solution thereby forming a coating film on the surface of the second substrate,
wherein operations for the prewetting step and the coating film forming step for each of the first and second substrates are performed by using an identical coating apparatus, and
wherein the surface tension of the prewetting liquid used in the prewetting step for the second substrate is different from the surface tension of the prewetting liquid used in the prewetting step for the first substrate, and the prewetting liquids having different surface tensions are obtained by mixing an identical solvent and an identical high surface tension liquid at different mixing ratios.

4. The coating method according to any one of claims 1 to 3, **characterized in that** the high surface tension liquid is GBL (γ-butyrolactone).

5. The coating method according to any one of claims 1 to 3, **characterized in that** the high surface tension liquid is pure water.

6. The coating method according any one of claims 1 to 5, **characterized in that** the solvent is a mixture of PGME (propylene glycol monomethyl ether) and PGMEA (propylene glycol monomethyl ether acetate).

7. The coating method according to any one of claims 1 to 5, **characterized in that** the solvent is CHN (cyclohexanone).

8. A coating method comprising:
a prewetting step of supplying a prewetting liquid to the center of a first substrate and rotating the first substrate thereby spreading the prewetting liquid over the whole surface of the first substrate; and
a coating film forming step of supplying a coating solution to the first substrate supplied with the prewetting liquid and drying the coating solution, thereby forming a coating film on the surface of the first substrate,
**characterized in that**:
the prewetting liquid is a mixed liquid, which is obtained by mixing a solvent capable of dissolving components of the coating film and a high surface tension liquid, and which has a surface tension higher than that of the solvent,
the solvent and the high surface tension liquid are separately prepared, and
the solvent and the high surface tension liquid are mixed when the prewetting liquid is supplied.

9. The coating method according to claim 8, **characterized by** further comprising:
a prewetting step of supplying a prewetting liquid to the center of a second substrate and rotating the second substrate thereby diffusing the prewetting liquid over the whole surface of the substrate; and
a coating film forming step of supplying, to the second substrate supplied with the prewetting liquid, a coating solution having a surface tension different from that of the coating solution supplied to the first substrate and drying the coating solution thereby forming a coating film on the surface of the second substrate, and
**characterized in that**:
operations for the prewetting step and the coating film forming step for each of the first and second substrates are performed by using an identical coating apparatus, and
the surface tension of the prewetting liquid used in the prewetting step for the second substrate is different from the surface tension of the prewetting liquid used in the prewetting step for the first substrate, and the prewetting liquids having different surface tensions are obtained by mixing an identical solvent and an identical high surface tension liquid at different mixing ratios.

10. A coating apparatus comprising:
a spin chuck (130) for holding and rotating a substrate (W);
at least one coating solution nozzle (143A, 143B) for supplying a coating solution to the surface of the substrate held by the spin chuck;
at least one prewetting nozzle (150A, 150B) for supplying a prewetting liquid to the surface of the substrate held by the spin chuck;
a coating solution supply mechanism (146A, 146B, 147A, 147B, 148A, 148B) for supplying the coating solution to the coating solution nozzle; and
a prewetting liquid supply mechanism for supplying the prewetting liquid to the prewetting nozzle,
**characterized in that**:
the prewetting liquid supply mechanism includes a prewetting liquid supply control section (156) connected to a supply source (154B) for a solvent capable of dissolving components of a coating film and a supply source (154A) for a high surface tension liquid having a surface tension higher than that of the solvent, the prewetting liquid supply control section being configured to mix the solvent and the high surface tension liquid and supply the mixture to the prewetting nozzle, and
the prewetting liquid supply control section is configured to variably control the mixing ratio of the solvent and the high surface tension liquid.

11. The coating apparatus according to claim 10, **characterized in that**:
the coating apparatus has a first prewetting nozzle (150B) and a second prewetting nozzle (150A) as at least one prewetting nozzle,
the prewetting liquid supply mechanism includes:
a first line (155B) having one end connected to the supply source (154B) for the solvent and the other end connected to the first prewetting nozzle (150B),
a second line (155A) having one end connected to the supply source (154A) for the high surface tension liquid and the other end connected to the second prewetting nozzle (150A), and
a connection line (157) for connecting the second line with the first line, and
the prewetting liquid supply control section (156) is configured to selectively provide a first state in which a prewetting liquid consisting only of the solvent supplied from the first prewetting nozzle and a second state in which a prewetting liquid comprising a mixed liquid of the solvent and the high surface tension liquid is supplied from the second prewetting nozzle, the prewetting liquid supply control section is configured to variably control the mixing ratio between the solvent and the high surface tension liquid in the second state.

12. The coating apparatus according to claim 11, **characterized in that** the prewetting liquid supply control section includes a first flow rate control valve (158) disposed on the first line, a second flow rate control valve (159) disposed on the second line, and a third flow rate control valve (160) disposed on the connection line.

13. The coating apparatus according to any one of claims 10 to 12, **characterized in that** the coating solution supply mechanism is configured to supply at least two types of coating solutions having different surface tensions to the surface of the substrate held by the spin chuck by way of at least one coating solution nozzle.

14. The coating apparatus according to any one of claims 10 to 13, **characterized in that** the high surface tension liquid is GBL (γ-butyrolactone).

15. The coating apparatus according to any one of claims 10 to 13, **characterized in that** the high surface tension liquid is pure water.

16. The coating apparatus according to any one of claims 10 to 15, **characterized in that** the solvent is a mixture of PGME (propylene glycol monomethyl ether) and PGMEA (propylene glycol monomethyl ether acetate).

17. The coating apparatus according to any one of claims 10 to 15, **characterized in that** the solvent is CHN (cyclohexanone).
